# EUROPEAN PATENT APPLICATION

(11) **EP 2 803 483 A1**
(43) Date of publication of application: **19.11.2014**
(21) Application number: 13735833.9
(22) Date of filing: 04.01.2013
(51) Int. Cl.: B32B 27/20, H01L 31/048

(54) **SOLAR CELL MODULE BACK SHEET, METHOD FOR MANUFACTURING SOLAR CELL MODULE BACK SHEET, AND SOLAR CELL MODULE**

(30) Priority: 13.01.2012 JP 2012005471
(71) Applicant: Keiwa Inc., Osaka-shi, Osaka 533-0006 (JP)
(72) Inventor: IHARA Kenji, Osaka-shi Osaka 533-0006 (JP)
(74) Representative: Schulz, Björn
(86) International application number: PCT/JP2013/050008
(87) International publication number: WO 2013/105522

(57) **Abstract**

An object of the present invention is to provide a back sheet for a solar battery module that is less likely to cause a rise in temperature by irradiation with rays of the sun even though displaying a black color in appearance, and is less likely to discolor even after a long-term use thereof while suppressing a rise in cost. The back sheet for a solar battery module according to the present invention includes a colored layer that includes three or more types of color materials each having a different hue and a brightness L* of no less than 45, the colored layer having a brightness L' of no greater than 40. It is preferred that the three or more types of color materials are constituted with at least a red color material, a blue color material and a yellow color material. Preferably, a base sheet on which the colored layer is laminated is further included. It is preferred that the base sheet displays a white color and the colored layer is laminated on the front face side of the base sheet. Moreover, the base sheet preferably includes a base film and a white layer laminated on the front face side of the base film.

## Description

### [TECHNICAL FIELD]

The present invention relates to a back sheet for a solar battery module, which is a constituting unit of a solar battery, and a solar battery module using the same.

### [BACKGROUND ART]

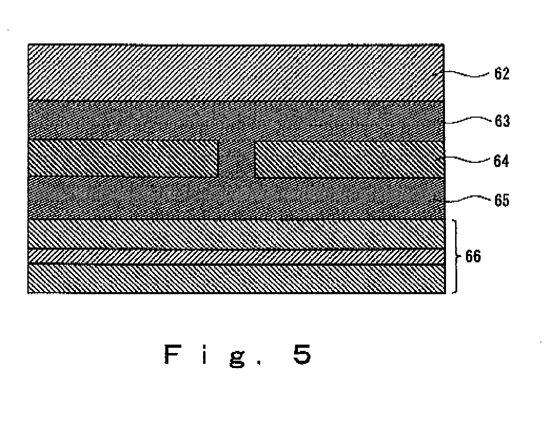

In recent years, solar photovoltaic electric power generation as a clean energy source has attracted attention owing to increasing awareness of environmental issues such as global warming, thereby leading to development of solar batteries having a variety of configurations. This solar battery Is constructed with a plurality of solar battery modules produced by packaging and unitizing a plurality of solar battery cells arranged. As shown in Fig. 5, in a general structure of the solar battery module, a transparent substrate 62 made of glass or the like, a filler layer 63 made from a thermoplastic resin such as an ethylene-vinyl acetate copolymer, a plurality of solar battery cells 64 as a photovoltaic device, a filler layer 65 that is similar to the filler layer 63, and a back sheet 66 for a solar battery module are overlaid in this order from the front face side to the back face side, and integrally molded by vacuum heat lamination or the like.

The back sheet 66 for a solar battery module can be seen from the front face side, through a gap between a plurality of solar battery cells 64. Besides, such solar battery modules are often installed on a roof of ordinary residential houses, and thus, a back sheet for a solar battery module having a black color similarly to the solar battery cell 64 may be used as the back sheet 66 for a solar battery module in light of appearance.

Sheets having a sheet base material into which a carbon black is incorporated are generally used as such a black-colored back sheet for a solar battery module. However, since the carbon black absorbs an infrared light among rays of the sun, irradiation of the back sheet for a solar battery module with rays of the sun causes the temperature thereof to be elevated. When the temperature of the solar battery module is elevated with the rise in temperature of the back sheet for a solar battery module, the efficiency of electric power generation of the solar battery module is decreased.

In view of such a circumstance, a back sheet for a solar battery module has been proposed which includes a black-colored resin layer into which a perylene-based black pigment is incorporated; as disclosed, for example, in Japanese Unexamined Patent Application, Publication No. 2007-128943, a colored resin layer that contains an infrared light-transmissive colorant is laminated on the front face of the base sheet, and a perylene-based black pigment Is used as the infrared light-transmissive colorant.

The perylene-based pigment Is a pigment that displays a color tone ranging from bright red (pigment red 149: PR149) through reddish brown (pigment red 179: PR179) to black, and displays a black color in a crystalline state and a red color in an amorphous state. Thus, as the perylene-based black pigment is altered from the crystalline state to the amorphous state due to disruption of the molecular arrangement thereof after a long-term use thereof, etc., it begins to develop a red color. Therefore, when a black-colored resin layer containing the perylene-based black pigment is provided in the back sheet for a solar battery module, the perylene-based black pigment may discolor after a long-term use, leading to impairment of initially-intended purposes of the black back sheet for a solar battery module. In addition, although there has also been developed a perylene-based black pigment that is treated so as to inhibit the discoloration, such a perylene-based black pigment is comparatively expensive, and when being used in the back sheet for a solar battery module, may cause an increase of costs.

### [PRIOR ART DOCUMENTS]

### [PATENT DOCUMENTS]

Patent Document 1: Japanese Unexamined Patent Application, Publication No. 2007-128943

### [SUMMARY OF THE INVENTION]

### [PROBLEMS TO BE SOLVED BY THE INVENTION]

The present invention was made in view of these disadvantages, and an object of the present invention is to provide a back sheet for a solar battery module that is less likely to cause a rise in temperature by irradiation with rays of the sun even though displaying a black color in appearance, and is less likely to discolor even after a long-term use thereof while suppressing an increase in costs, as well as a solar battery module using the same.

### [MEANS FOR SOLVING THE PROBLEMS]

The present invention was made for solving the aforementioned problems. According to an aspect of the present invention, a back sheet for a solar battery module includes a colored layer that includes three or more types of color materials each having a different hue and a brightness L" of no less than 45, the colored layer having a brightness L* of no greater than 40.

The back sheet for a solar battery module according to the aspect of the present invention is used in a state of being disposed on the back face side of a solar battery module including a solar battery cell. According to the back sheet for a solar battery module, since the three or more types of color materials of the colored layer differ in their hue from one another and the colored layer has a brightness L" of no greater than 40, there are advantages that the colored layer displays a substantially black color and a viewer hardly distinguishes the colored layer from solar battery cells. Moreover, since the three or more types of color materials are each likely to absorb a visible light ray of a specific wavelength but less likely to absorb an infrared light, a rise in temperature caused by the irradiation with rays of the sun can be suppressed despite the black color displayed by the colored layer. Further, since each color material of the colored layer has a brightness L* of no less than 45, ordinary color materials may be used and the use of a special color material is unnecessary, leading to suppression of an increase in costs. Moreover, discoloration is less likely to occur even after a long-term use, as compared with conventional perylene-based black pigments.

In addition, it is preferred that the back sheet for a solar battery module according to the aspect of the present invention further includes a base sheet on which the colored layer is laminated. Thereby, the colored layer can be easily and stably provided.

In a case where the base sheet is provided as mentioned above, it is preferred that the base sheet displays a white color and the colored layer is laminated on the front face side of the base sheet. Thus, rays of light (for example, an infrared light) that pass through the colored layer among the rays of light that enter the colored layer from the front face side of the colored layer are reflected by the base sheet that displays a white color, and a part of the reflected rays of light pass again through the colored layer and exit from the front face side. Since a part of the rays of light reflected by the base sheet and passed again through the colored layer in this manner enter the solar battery cell, the efficiency of photoelectric conversion of the solar battery module can be increased, and therefore the efficiency of electric power generation can be Increased.

In a case where the base sheet displays a white color as mentioned above, a base sheet that Includes a base film, and a white layer laminated on the front face side of the base film is preferably employed. Thus, the base sheet that displays a white color can be easily and reliably provided, and the rays of light can be reflected by the white layer provided on the front face side of the base sheet. Therefore, the efficiency of reflection of the rays of light by the base sheet can be increased.

Moreover, in a case where the base sheet is provided as mentioned above, the colored layer is preferably provided substantially in a grid pattern in a planar view. Thus, when solar battery cells are disposed such that the solar battery cells cover a gap portion in a planar view (a portion that is partitioned by the grid pattern) of the colored layer of the back sheet for a solar battery module, the entire surface of the solar battery module displays a black color when viewed from the front face side. More specifically, by providing the colored layer of the back sheet for a solar battery module such that the colored layer is located on a gap portion between the respective solar battery modules in accordance with positions of a plurality of solar batteries to be disposed, the entire solar battery module in a planar view can display a black color in spite of a small area of the colored layer. Since the area in which the colored layer is provided can be reduced in this manner, a further reduction of costs can be attained.

Moreover, according to the back sheet for a solar battery module, It is preferred that the three or more types of color materials are constituted with at least a red color material, a blue color material and a yellow color material. Thus, the colored layer is allowed to display a black color by merely using generally-used color materials.

Furthermore, according to the back sheet for a solar battery module, the color material is preferably a pigment. When a generally-used pigment is thus used as the color material, the colored layer exhibiting superior durability can be obtained at a lower cost.

Further, according to another aspect of the present invention, a method for producing a back sheet for a solar battery module includes providing a colored layer on one face side of a base sheet by applying a material for forming a colored layer that includes three or more types of color materials each having a different hue and a brightness L* of no less than 45. Thus, the back sheet for a solar battery module having the aforementioned advantages can be produced.

Furthermore, according to still another aspect of the present invention, a solar battery module includes a transparent substrate, a filler layer, a solar battery cell as a photovoltaic device, a filler layer, and the back sheet for a solar battery module having the aforementioned structure, overlaid in this order from the front face side. Thus, the colored layer displays a substantially black color, and a viewer hardly distinguishes the colored layer from solar battery cells. Moreover, the back sheet for a solar battery module is less likely to absorb an infrared light, and a rise in temperature caused by the irradiation with rays of the sun can be suppressed. In addition, generally-used color materials can be used as the color material of the colored layer of the back sheet for a solar battery module, and therefore only a low cost is necessary and discoloration hardly occurs.

It is to be noted that "brightness L"" as referred to means a numerical value defined in JIS-Z8729, and "a colored layer has a brightness L* of no greater than 40" as referred to means that a value of the brightness L* is determined to be no greater than 40 when the brightness L" is determined on the back sheet including a colored layer that includes at least three or more types of color materials as mentioned above from the side from where the colored layer can be seen. In addition, "a color material has a brightness L" of no less than 45" means that when one type of the color material unaccompanied by other color materials is blended in an identical blend amount and a layer having an identical thickness to the colored layer is provided, the layer has a brightness L* of no less than 45. Further, the term "color material" encompasses pigments and dyes. Moreover, the term "front face" means a face on a light-receiving side of a solar battery module or a back sheet constituting the solar battery module.

### [EFFECTS OF THE INVENTION]

As explained in the foregoing, the back sheet for a solar battery module according to the aspect of the present invention Is less likely to cause a rise In temperature due to irradiation with rays of the sun even though displaying a black color in appearance, and additionally is less likely to discolor even after a long-term use thereof while suppressing a rise in cost.

### [BRIEF DESCRIPTION OF THE DRAWINGS]

Fig. 1 is a schematic cross sectional view illustrating a back sheet for a solar battery module according to an embodiment of the present invention;
Fig. 2 is a schematic cross sectional view illustrating a solar battery module using the back sheet for a solar battery module shown in Fig. 1;
Fig. 3 is a schematic cross sectional view illustrating a back sheet for a solar battery module according to an embodiment other than the back sheet for a solar battery module shown in Fig. 1;
Fig. 4 is a schematic plan view of a back sheet for a solar battery module according to an embodiment other than the back sheet for a solar battery module shown in Fig. 1;
Fig. 5 is a schematic cross sectional view illustrating a conventional general solar battery module;
Fig. 6 is a graph illustrating a relationship between a wavelength and a reflectance in the irradiation of a back sheet for a solar battery module according to an embodiment of the present invention with rays of the sun; and
Fig. 7 is a graph illustrating a relationship between a wavelength and a reflectance in the irradiation of a back sheet for a solar battery module according to an embodiment of the present invention or a back sheet having a carbon black applied on the front face thereof were irradiated with rays of the sun.

### [DESCRIPTION OF EMBODIMENTS]

### Configuration of Back Sheet 1 for Solar Battery Module

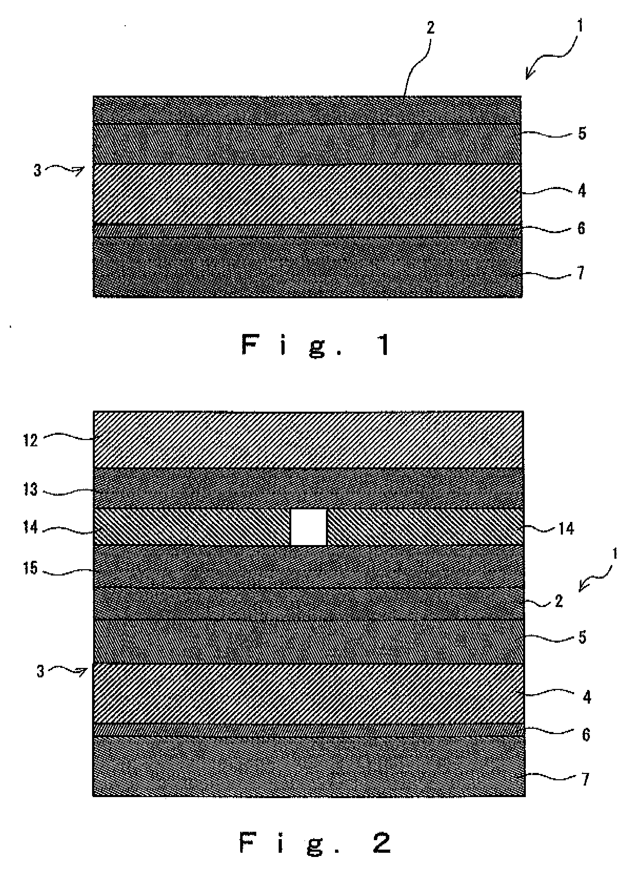

The back sheet 1 for a solar battery module shown in Fig. 1 (hereinafter, may be referred to as "back sheet 1") includes a colored layer 2, and a base sheet 3 on which the colored layer 2 Is laminated, the colored layer 2 containing three or more types of color materials each having a different hue and a brightness L" of no less than 45, and having a brightness L" of no greater than 40. The back sheet 1 also includes a gas barrier layer 6 that is laminated on the back face side of the base sheet 3, and a back face side base sheet 7 that is laminated on the back face side of the gas barrier layer 6.

### Colored Layer 2

The colored layer 2 is laminated on the front face side of the base sheet 3, and is formed from a resin layer that contains a pigment (color material).

Inorganic pigments and organic pigments can be used as the pigment, and inorganic pigments are preferably used in light of costs and durability thereof. Moreover, a red color pigment, a blue color pigment and a yellow color pigment are preferably used as the three or more types of pigments that are contained in the colored layer 2 and each have a different hue. Note that other pigments, e.g., a green color pigment, an orange color pigment, a purple color pigment, a green color pigment or the like may be used as the pigment.

In this regard, red-colored inorganic pigments such as red lead and red Iron oxide and red-colored organic pigments such as anthraquinones, quinacridones and diketopyrrolopyrroles may be used as the red color pigment. Moreover, blue-colored inorganic pigments such as ultramarine blue and Prussian blue and blue-colored inorganic pigments such as phthalocyanines, anthraquinones and indigoids may be used as the blue color pigment. Chrome yellow, zinc yellow (zinc yellow type 1 and zinc yellow type 2), as well as yellow-colored organic pigments such as isoindolinones, quinophtharones, isaindolines, anthraquinones, anthrones and xanthenes may be used as the yellow color pigment. In addition, phthalocyanines, azomethines and the like may be used as the green color pigment. Diketopyrrolopyrroles, perylenes, inthraquinones (anthrones), perynones, quinacridones, indigoids and the like may be used as the orange color pigment. Dioxazines, quinacridones, perylenes, indigoids, anthraquinones (anthrones), xanthenes and the like may be used as the purple color pigment.

The mean particle size of the pigment falls within a range of preferably no less than 100 nm and no greater than 30 µm, and particularly preferably no less than 200 nm and no greater than 20 µm, When the mean particle size of the pigment is below the above range, it may be difficult to homogeneously disperse the pigment. To the contrary, when the mean particle size of the pigment is beyond the above range, the pigments respectively displaying each color may be difficult to be dispersed homogeneously as viewed from a plane.

The average thickness of the colored layer 2 falls within a range of preferably no less than 1 µm and no greater than 300 µm, more preferably no less than 3 µm and no greater than 150 µm, and particularly preferably no less than 5 µm and no greater than 50 µm. When the average thickness is less than the above lower limit, a sufficient amount of the pigment may not be added, whereas when the average thickness is greater than the above upper limit, the colored layer 2 is too thick and the flexibility of the back sheet 1 may be impaired.

The amount of the pigment blended (the amount, in terms of solid content equivalent, of the total pigments contained in the colored layer 2 with respect to 100 parts by mass of the base polymer in the polymer composition, which is a material for forming the resin layer) is preferably no less than 80 parts by mass, more preferably no less than 100 parts by mass, and still more preferably no less than 130 parts by mass. In addition, the amount of the pigment blended is preferably no greater than 300 parts by mass, more preferably no greater than 200 parts by mass, and still more preferably no greater than 150 parts by mass. When the amount of the pigment blended is below the above range, rays of light having a desired wavelength may be less likely to be absorbed and it is necessary to provide a thick colored layer 2 in order to decrease the brightness L"; on the other hand, when the amount of the pigment blended is beyond the above range, the strength of the colored layer 2 may be deteriorated.

Although the blend ratio of the plurality of types of pigments is not particularly limited as long as the plurality of types of pigments are blended such that the brightness L" of the colored layer 2 is no greater than a predetermined value, the plurality of types of pigments contained in the colored layer 2 preferably include a basic pigment in an amount of no less than 20 parts by mass with respect to the total pigments, and an auxiliary pigment in an amount of no greater than 20 parts by mass with respect to the total pigments.

In this regard, the basic pigment is constituted with at least two, preferably three, types of pigments each having a different hue, and it is particularly preferred that each of the "three or more types of color materials each having a different hue and a brightness L" of no less than 45" as described above is the aforementioned basic pigment, Specifically, a red color pigment, a blue color pigment and a yellow color pigment are preferably used as the basic pigment, and in particular, an inorganic pigment is preferably used in light of costs and durability thereof The total amount of the basic pigment with respect to the entirety of the pigments is preferably no less than 70 parts by mass, more preferably no less than 80 parts by mass, and still more preferably no less than 90 parts by mass.

Further, a pigment that absorbs rays of light within a wavelength range in which a layer provided using the basic pigment alone is likely to be transmissive is preferably used as the auxiliary pigment. In this regard, either one, or two or more types of the auxiliary pigment may be used, and the total amount of the auxiliary pigment blended with respect to the total pigments is preferably no greater than 30 parts by mass, more preferably no greater than 20 parts by mass, and still more preferably no greater than 10 parts by mass.

It is to be noted that the pigment has a brightness L" of preferably no less than 45, more preferably no less than 50, and still more preferably no less than 55. In addition, the brightness L" of a pigment means a brightness L* as determined on a layer that is formed in a similar manner to the aforementioned colored layer 2 using an identical amount of the pigment blended alone and excluding other pigments which may be contained in the colored layer 2. In other words, in a case where the amount of the red color pigment blended in the colored layer 2 (the amount of the red color pigment contained in the colored layer 2 in terms of solid content equivalent with respect to 100 parts by mass of the base polymer in the polymer composition, which Is a material for forming the resin layer) is 30 parts by mass, the brightness L* of a pigment means a brightness L" of a layer formed with an identical thickness to the colored layer 2 after adding the amount of the red color pigment blended (the amount of the red color pigment blended in terms of solid content equivalent with respect to 100 parts by mass of the base polymer), I.e., 30 parts by mass, to a material identical to the material for forming the resin layer of the colored layer 2.

Moreover, the colored layer 2 has a brightness L" of preferably no greater than 40, more preferably no greater than 30, and still more preferably no greater than 10. It is to be noted that the brightness L* of the colored layer 2 means a brightness L* as determined on the back sheet 1 from the front face side.

The colored layer 2 is a resin layer to be melted by heating for the purpose of laminating the back sheet 1 through adhesion to form a solar battery module, and may be made from, for example, a resin layer that contains an ethylene polymer as a principal component.

Polyethylene such as low density polyethylene, medium density polyethylene and high density polyethylene, an ethylene-α-olefin copolymer, an ethylene-(meth)acrylic acid alkyl ester copolymer, an ethylene-(meth)acrylic acid copolymer, an ionically-crosslinked product of ethylene-(meth)acrylic acid copolymers, an ethylene-vinyl ester copolymer or the like may be used as the ethylene polymer. These may be used alone, or two or more types thereof may be used in combination.

Examples of the α-olefin constituting the ethylene-α-olefin copolymer include propylene, butene-1, hexene-1, octene-1,4-methylpentene-1, and the like.

Examples of the (meth)acrylic acid alkyl ester constituting the ethylene-(meth) acrylic acid alkyl ester copolymer include methyl acrylate, ethyl acrylate, isopropyl acrylate, isobutyl acrylate, n-butyl acrylate, isooctyl acrylate, 2-ethylhexyl acrylate, methyl methacrylate, ethyl methacrylate, isobutyl methacrylate, and the like.

Examples of the (meth)acrylic acid constituting the ethylene-(meth)acrylic acid copolymer include acrylic acid, methacrylic acid, fumaric acid, maleic acid, maleic anhydride, and the like.

Examples of the vinyl ester constituting the ethylene-vinyl ester copolymer include vinyl acetate, vinyl propionate, and the like.

Further, ethylene polymers in which a compound having a reactive functional group such as a glycidyl group, a silanol group and an amino group is copolymerized may also be used.

In addition, an additive such as an ultraviolet ray-absorbing agent, a light stabilizer and an antioxidant may be blended into a material for forming the colored layer 2. In this case, it is preferred that the additive (any one, or two or more of the ultraviolet ray-absorbing agent, the light stabilizer and the antioxidant) is polymer-immobilized. Additives conventionally used in the back sheet 1 may also be used as the additive. For example, an additive such as an organic peroxide, a crosslinking accelerator and a silane coupling agent may be blended into the material for forming the colored layer 2.

An organic peroxide having a decomposition temperature at which a half-life of 10 hours is attained of no greater than 145° C is preferably employed as the organic peroxide in light of the reactivity thereof. As the organic peroxide having a decomposition temperature at which a half-life of 10 hours is attained of no greater than 145 °C, dilauroyl peroxide, 1,1,3,3,-tetramethylbutyl peroxy-2-ethylhexanoate, dibenzoyl peroxide, t-amyl peroxy-2-ethylhexanoate, t-butyl peroxy-2-ethylhexanoate, t-butyl peroxyisobutyrate, t-butyl peroxymaleate, 1,1-di(t-amylperoxy)-3,3,5-trimethylcyclohexane, 1,1-di(t-amylperoxy)cyclo-hexane, t-amyl peroxyisononanoate, t-amyl peroxy-n-octoate, 1,1-di(t-butylperoxy)-3,3,5-trimethylcyclohexane, 1,1-di(t-butylperoxy)cyclohaxane, t-butyl peroxyisopropyl carbonate, t-butyl peroxy-2-ethylhexyl carbonate, 2,5-dimethyl-2,5-di(benzoylperoxy)hexane, t-amyl peroxybenzoate, t-butyl peroxyacetate, t-butyl peroxyisononanoate, t-butyl peroxybenzoate, n-butyl 4,4-di-(t-butylperoxy)valerate, di(2-t-butylperoxypropyl)benzene, dicumyl peroxide, 2,5-dimethyl-2,5-di(t-butylperoxy)hexane, t-butyl cumyl peroxide, di-t-butyl peroxide, 2,5-dimethyl-2,5-di(t-butylperoxy)hexyne-3 and the like can be used. These organic peroxides may be used either one type alone, or in combination of two or more types thereof.

The amount of the organic peroxide blended with respect to 100 parts by mass of the ethylene polymer is preferably no less than 0.05 parts by mass and no greater than 5 parts by mass, and more preferably no less than 0.1 parts by mass and no greater than 2.0 parts by mass. When the amount of the organic peroxide blended is less than the above lower limit, the formation of the cross-linked structure may be insufficient, whereas when the amount of the organic peroxide blended is greater than the above upper limit, excessive reactions may take place, and as a result, the ethylene polymer may be deteriorated through the degradation thereof and the like.

The crosslinking accelerator is an auxiliary agent for improving the mechanical strength and the like of the colored layer 2 by increasing the degree of crosslinking of the ethylene polymer. For example, a compound that has a (meth)acryloxy group, a compound that has an allyl group, and the like may be used as the crosslinking accelerator.

Examples of the compound that has a (meth)acryloxy group Include (meth)acrylic acid alkyl esters, (meth)acrylic acid amides, and the like. Examples of the alkyl group in the (meth)acrylic acid alkyl esters include methyl, ethyl, dodecyl, and the like.

The amount of the crosslinking accelerator blended with respect to 100 parts by mass of the ethylene polymer is preferably no less than 0.05 parts by mass and no greater than 5 parts by mass, and more preferably no less than 0.1 parts by mass and no greater than 2.0 parts by mass. When the amount of the crosslinking accelerator blended is less than the above lower limit, the formation of the cross-linked structure may be insufficient, whereas when the amount of the crosslinking accelerator blended is greater than the above upper limit, the ethylene polymer may be deteriorated as a result of excessive reactions thereof.

Further, a photopolymerization initiator may be added to the ethylene polymer such that photopolymerization is allowed to take place.

For example, a hydrogen-abstracting photopolymerization initiator and an internally-cleavable photopolymerization initiator may be used as the photopolymerization initiator.

Examples of the hydrogen-abstracting (bimolecular reaction-type) photopolymerization initiator include benzophenone, methyl orthobenzoylbenzoate, 4-benzoyl-4'-methyldiphenyl sulfide, isopropylthiaxanthon, and the like.

Moreover, a benzoin alkyl ether, benzyl dimethyl ketal, or the like can be used as the internally-cleavable photopolymerization initiator. Moreover, α-hydroxyalkylphenone-type polymerization initiators such as 2-hydroxy-2-methyl-1-phenylpropane-1-one, 1-hydroxycyclohexyl phenyl ketone, alkylphenyl glyoxylate and diethoxyacetophenone; α-aminoalkylphenone-type polymerization initiators such as 2-methyl-1-[4-(methylthio) phenyl]-2-morpholinopropane-1 and 2-benzyl-2-dimethylamino-1-(4-morpholinophenyl)-butanone-1; acylphosphine oxides; and the like may be used.

Examples of the silane coupling agent include vinyltriethoxysilane, vinyltris(β-mothoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropyltrimethoxysilane, γ-aminopropyltriethoxysilane, N-β(aminoethyl)-γ-aminopropyltrimethoxysilane, and the like. The amount of the silane coupling agent blended with respect to 100 parts by mass of the ethylene polymer is preferably no less than 0.1 parts by mass and 5 parts by mass. When the amount of the silane coupling agent blended is less than the above lower limit, adhesiveness may be deteriorated, whereas when the amount of the silane coupling agent blended is greater than the above upper limit, sufficient heat resistance, light resistance and weather resistance may not be exhibited.

The colored layer 2 is provided by applying to the front face of the base sheet 3 (white layer 5) a coating liquid prepared by incorporating a pigment into a polymer composition which is a material for forming the resin layer. Specifically, the colored layer 2 may be provided by preparing a coating liquid by dissolving or dispersing the pigment in the polymer composition, and applying the coating liquid to the front face of the base sheet 3 by a coating method such as a dipping method, a flow coating method, a spray coating method, a bar coating method, a gravure coating method, a roll coating method, blade coating method and an air knife coating method, followed by curing. Alternatively, as the method for providing the colored layer 2, a method may be employed in which a mixture of the pigment and the polymer composition is molded into a film or a sheet using a process such as photo-curing, injection molding, T die molding, calendar molding, compression molding and casting, followed by adhesion of the film or the sheet to the front face of the base sheet 3, and the like. However, the colored layer 2 can be easily and reliably provided by providing the colored layer 2 through the coating, as mentioned above.

### Base Sheet 3

The base sheet 3 displays a white color when viewed from the front face side, and includes a base film 4 made from a synthetic resin and a white layer 5 laminated on the front face side of the base film 4.

The front face of the base sheet 3 preferably has a reflectance of no less than 80.5%, whereby rays of light that pass through the colored layer 2 and enter the front face of the base sheet 3 can be accurately reflected. Moreover, the front face of the base sheet 3 has a whiteness degree of preferably no less than 80%, more preferably no less than 90%, and still more preferably no less than 94%. Thus, the light that enters the base sheet 3 from the front face side can be accurately reflected.

### Base Film 4

Although the synthetic resin used in the base film 4 is not particularly limited, examples thereof include polyethylene resins, polypropylene resins, cyclic polyolefin resins, polystyrene resins, acrylonitrile-styrene copolymers (AS resins), acrylonitrile-butadienestyrene copolymers (ABS resins), polyvinyl chloride resins, fluorine-containing resins, poly(meth)acrylic resins, polycarbonate resins, polyester resins, polyamide resins, polyimide resins, polyamideimide resins, polyarylphthalate resins, silicone resins, polysulfone resins, polyphenylene sulfide resins, polyethersulfone resins, polyurethane resins, acetal resins, cellulose resins, and the like. Among the aforementioned resins, polyester resins, fluorine-containing resins and cyclic polyolefin resins are preferred since these resins have superior heat resistance, strength, weather resistance, durability, barrier properties against gases such as water vapor, and the like, can withstand conditions for applying the white layer 5, and exhibit superior adhesiveness to the white layer 5.

Examples of the polyester resin Include polyethylene terephthalate, polyethylene naphthalate, and the like. Among these polyester resins, polyethylene terephthalate which allows for a favorable harmony of costs and various functions including the heat resistance, the weather resistance and the like is particularly preferred.

Examples of the fluorine-containing resins Include polytetrafluoroethylenes (PTFE), perfluoroalkoxy resins (PFA) containing a copolymer of tetrafluoroethylene with a perfluoroalkyl vinyl ether, copolymers of tetrafluoroethylene with hexafluoropropylene (FEP), copolymers of tetrafluoroethylene, perfluoroalkyl vinyl ether and hexafluoropropylene (EPE), copolymers of tetrafluoroethylene with ethylene or propylene (ETFE), polychlorotrifluoroethylene resins (PCTFE), copolymers of ethylene with chlorotrifluoroethylene (ECTFE), vinylidene fluoride resins (PVDF), vinyl fluoride resins (PVF), and the like. Among these fluorine-containing resins, polyvinyl fluoride resins (PVF) and copolymers of tetrafluoroethylene with ethylene or propylene (ETFE) are particularly preferred in light of superior strength, heat resistance, weather resistance and the like thereof.

Examples of the cyclic polyolefin resin include: a) polymers obtained by polymerizing a cyclic diene such as cyclopentadiene (and a derivative thereof), dicyclopentadiene (and a derivative thereof), cyclohexadiene (and a derivative thereof) and norbornadiene (and a derivative thereof); b) copolymers obtained by copolymerizing the cyclic diene with one type, or two or more types of olefin monomers such as ethylene, propylene, 4-methyl-1-pentene, styrene, butadiene and isoprene; and the like. Among these cyclic polyolefin resins, polymers of a cyclic diene such as cyclopentadiene (and a derivative thereof), dicyclopentadiene (and a derivative thereof) or norbornadiene (and a derivative thereof) are particularly preferred in light of their superior strength, heat resistance, weather resistance, and the like.

It is to be noted that the synthetic resin may be used either alone, or as a mixture of two or more types thereof as a material for forming the base film 4. In addition, various additives and the like may be blended in the material for forming the base film 4 for the purpose of improving and/or modifying the processability, heat resistance, weather resistance, mechanical property, dimension accuracy, etc. Examples of the additives include lubricants, crosslinking agents, antioxidants, ultraviolet ray-absorbing agents, light stabilizers, fillers, reinforcing fibers, reinforcing agents, antistatic agents, fire retardants, flame-resistant agents, foaming agents, fungicides, pigments, and the like. Although the method for molding the base film 4 is not particularly limited, well-known processes such as, for example, an extrusion process, a cast molding process, a T die process, a skiving process and an inflation molding may be employed.

The lower limit of the thickness (average thickness) of the base film 4 is preferably 10 µm, and particularly preferably 20 µm. On the other hand, the upper limit of the thickness of the base film 4 is preferably 250 µm, and particularly preferably 188 µm. When the base film 4 has a thickness less than the above lower limit, there may be caused disadvantages that: curling is likely to occur in the coating processing of the beads-coated layer 3; and a difficulty of handling may arise; and the like. To the contrary, when the base film 4 has a thickness greater than the above upper limit, demands for reduction in thickness and weight of the solar battery module 11 may not be satisfied.

### White Layer 5

The white layer 5 is laminated on the front face side of the base film 4, and made from a resin layer that contains a white pigment.

Titanium oxide (titanium white) is suitably used as the white pigment. The material of the white pigment is not particularly limited, and for example, zinc oxide (zinc white), lead carbonate (lead white), barium sulfate, calcium carbonate (chalk) and the like may also be used. However, titanium oxide is preferably used in light of improvement of a whiteness degree and reflectance.

The front face of the white layer 5 is preferably substantially smooth. Specifically, the arithmetic average roughness (Ra) of the three-dimensional surface roughness of the front face of the white layer 5 is preferably no greater than 3 µm, more preferably no greater than 2 µm, and particularly preferably no greater than 1 µm. When the front face of the white layer 5 is substantially smooth, the thickness of the colored layer 2 is likely to be uniform, and consequently the back sheet 1 is less likely to be uneven in terms of its color when viewed from the front face side.

The white pigment has a mean particle size of preferably no less than 100 nm and no greater than 30 µm, and particularly preferably no less than 200 nm and no greater than 20 µm. The reasons for the above range are presumed as follows: when the white pigment has a mean particle size below the above range, the whiteness degree and reflectance of the white layer 5 may be excessively reduced, and to the contrary, when the white pigment has a mean particle size beyond the above range, the white pigment may cause roughness on the front face of the white layer 5.

The white layer 5 has an average thickness of preferably no less than 5 µm and no greater than 500 µm, more preferably no less than 10 µm and no greater than 200 µm, and particularly preferably no less than 50 µm and no greater than 100 µm. When the average thickness is less than the above lower limit, a sufficient amount of the pigment may not be added, whereas when the average thickness is greater than the above upper limit, the white layer 5 may be so thick that the flexibility of the back sheet 1 may be impaired.

The amount of the white pigment blended (the amount, in terms of solid content equivalent, of the total white pigments contained in the white layer 5 with respect to 100 parts by mass of the base polymer in the polymer composition which is a material for forming the resin layer) is preferably no less than 80 parts by mass, more preferably no less than 100 parts by mass, and still more preferably no less than 130 parts by mass. In addition, the amount of the pigment blended is preferably no greater than 300 parts by mass, more preferably no greater than 200 parts by mass, and still more preferably no greater than 150 parts by mass. When the amount of the white pigment blended Is below the above range, the whiteness degree and reflectance may be excessively reduced, whereas when the amount of the white pigment blended is beyond the above range, the white pigment may cause roughness on the front face of the white layer 5.

The white layer 5 is a resin layer to be partially melted by heating for the purpose of laminating the back sheet 1 through adhesion to form a solar battery module, and the similar resins to those which are used for providing the above-described colored layer 2 may be used. In addition, methods similar to those for laminating the colored layer 2 as described above may be employed as the method for laminating the white layer 5.

### Gas Barrier Layer 6

The gas barrier layer 6 functions to reduce permeation of a gas such as a hydrogen gas and an oxygen gas. The gas barrier layer 6 includes a film- or sheet-shaped base material (not shown in the figures) and an inorganic oxidization layer laminated on the base material (not shown in the figures). It is to be noted that the gas barrier layer may be made of an aluminum foil or the like.

The base material of the gas barrier layer 6 Is formed using a synthetic resin as a principal component. Similar synthetic resins to those for the base film 4 of the base sheet 3 may be used for the synthetic resin as a principal component of the base material, and among these, polyethylene terephthalate is particularly preferred in light of a favorable harmony of costs and various functions including heat resistance, weather resistance and the like. Moreover, the method for molding the base material as well as the additives in a material for forming the base material, and the like are similar to those for the base film 4 of the base sheet 3.

The lower limit of the thickness (average thickness) of the base material of the gas barrier layer 6 is preferably 7 µm, and particularly preferably 10 µm. On the other hand, the upper limit of the thickness of the base material is preferably 20 µm, and particularly preferably 15 µm. When the thickness of the base material is less than the above lower limit, there may be caused disadvantages that: curling is likely to occur in vapor deposition processing for providing the inorganic oxide layer; and a difficulty of handling may arise; and the like. To the contrary, when the thickness of the base material is greater than the above upper limit, demands for reduction in thickness and weight of the solar battery module may not be satisfied.

The inorganic oxide layer exhibits gas barrier properties against oxygen, water vapor and the like, and is provided by vapor-depositing an inorganic oxide on the back face of the base material. Vapor deposition means for providing the Inorganic oxide layer is not particularly limited as long as the inorganic oxide can be vapor-deposited on the base material made from a synthetic resin without causing deterioration such as shrinkage or yellowing, and (a) physical vapor deposition (PVD) such as vacuum evaporation, sputtering, ion plating and ion cluster beam methods; and (b) chemical vapor deposition (CVD) such as plasma chemical vapor deposition, thermal chemical vapor deposition and photochemical vapor deposition may be employed. Among these vapor deposition processes, vacuum evaporation and ion plating are preferred in light of their possibility to produce an inorganic oxide layer having high quality with high productivity,

The inorganic oxide constituting the inorganic oxide layer is not particularly limited as long as it exhibits gas barrier properties, and for example, aluminum oxides, silica oxides, titanium oxides, zirconium oxides, zinc oxides, tin oxides, magnesium oxides or like may be used. Of these, aluminum oxides or silicon oxides are particularly preferred in light of a favorable harmony of costs and gas barrier properties.

The lower limit of the thickness (average thickness) of the inorganic oxide layer is preferably 3 Å, and particularly preferably 400 Å. On the other hand, the upper limit of the thickness of the inorganic oxide layer is preferably 3,000 Å, and particularly preferably 800 Å. When the thickness of the inorganic oxide layer is less than the above lower limit, gas barrier properties may be deteriorated. On the other hand, when the thickness of the inorganic oxide layer is greater than the above upper limit, the flexibility of the Inorganic oxide layer may be impaired, whereby defects such as cracks are likely to occur.

The inorganic oxide layer may have either a monolayer structure, or a multilayer structure that includes two or more layers. When the inorganic oxide layer thus has a multilayer structure, deterioration of the base material can be minimized through reduction of thermal burden applied during the vapor deposition, and further, adhesiveness between the base material and the inorganic oxide layer can be improved. In addition, conditions of the vapor deposition employed in the physical vapor deposition or the chemical vapor deposition may be arbitrarily determined in accordance with the resin type of the base material, the thickness of the inorganic oxide layer, and the like.

In addition, in order to improve coherent adhesiveness and the like between the base material and the inorganic oxide layer, one face to be subjected to the vapor deposition of the base material may be subjected to a surface treatment. Examples of such a surface treatment for improving the adhesiveness include (a) a corona discharge treatment, an ozone treatment, a low temperature plasma treatment using an oxygen gas, a nitrogen gas or the like, a glow discharge treatment, and oxidizing treatments using a chemical or the like; (b) a primer coating treatment, an undercoat treatment, an anchor coating treatment, a vapor deposition anchor coating treatment; and the like. Among these surface treatments, a corona discharge treatment and an anchor coating treatment are preferred since these treatments achieve enhancement of the adhesive strength to the inorganic oxide layer, and lead to formation of a compact and uniform inorganic oxide layer.

Examples of the anchor coating agent which may be used in the anchor coating treatment include e.g., polyester-based anchor coating agents, polyamide-based anchor coating agents, polyurethane-based anchor coating agents, epoxy-based anchor coating agents, phenol-based anchor coating agents, (meth)acrylic anchor coating agents, polyvinyl acetate-based anchor coating agents and anchor coating agents based on a polyolefin such as polyethylene or polypropylene, cellulose-based anchor coating agents, and the like. Among these anchor coating agents, polyester-based anchor coating agents which can further enhance the adhesive strength between the base material and the inorganic oxide layer are particularly preferred.

The lower limit of the amount of coating (in terms of solid content equivalent) of the anchor coating agent is preferably 0.1 g/m², and particularly preferably 1 g/m². On the other hand, the upper limit of the amount of coating of the anchor coating agent preferably 5 g/m², and particularly preferably 3 g/m². When the amount of coating of the anchor coating agent is less than the above lower limit, the effect of improving the adhesiveness between the base material and the Inorganic oxide layer may be decreased. On the other hand, when the amount of coating of the anchor coating agent is greater than the above upper limit, the strength, durability and the like of the back sheet 1 may be deteriorated.

In the anchor coating agent described above, a variety of additives such as a silane coupling agent for improving coherent adhesiveness, an antiblocking agent for preventing blocking with the base material, an ultraviolet ray-absorbing agent for improving weather resistance, and the like may be blended arbitrarily. The amount of such additives blended is preferably no less than 0.1% by weight and no greater than 10% by weight in light of the balance of the effect exhibited by the additive and possible inhibition of the function to be performed by the anchor coating agent.

### Back Face Side Base Sheet 7

The back face side base sheet 7 is formed using a synthetic resin as a principal component. As the synthetic resin that is the principal component of the hydrolysis-resistant resin layer, polyethylene naphthalate (PEN) which has superior hydrolysis resistance and heat resistance is used.

Polyethylene naphthalate as referred to is a polyester resin that constitutes ethylene naphthalate as a principal repeating unit, and synthesized using a naphthalenedicarboxylic acid as a principal dicarboxylic acid component and ethylene glycol as a principal glycol component.

The ethylene naphthalate unit preferably accounts for no less than 80 mol% with respect to the total repeating unit of the polyester. When the proportion of the ethylene naphthalate unit is less than 80 mol%, the hydrolysis resistance, strength and barrier properties of polyethylene naphthalate may be deteriorated.

The naphthalenedicarboxylic acid is exemplified by 2,6-naphthalenedicarboxylic acid, 1,4-naphthalenedicarboxylic acid, 1,5-naphthalenedicarboxylic acid, 1,3-naphthalenedicarboxylic acid and the like, and 2,6-naphthalenedicarboxylic acid is particularly preferred in light of the aforementioned hydrolysis resistance, and the like.

The back face side base sheet 7 preferably contains a carbodiimide compound in polyethylene naphthalate, which is the principal component. When the carbodiimide compound is thus contained as mentioned above, the hydrolysis resistance of the back face side base sheet 7 may be significantly improved. The content of the carbodiimide compound is preferably no less than 0.1 parts by mass and no greater than 10 parts by mass, and particularly preferably no less than 0.5 parts by mass and no greater than 3 parts by mass. When the content of the carbodiimide compound thus falls within the above range, the hydrolysis resistance of the back face side base sheet 7 may be effectively enhanced.

Examples of the carbodiimide compound include: (a) monocarbodiimides such as N,N'-diphenylcarbodiimide, N,N'-diisopropylphenylcarbodiimide, N,N'-dicyclohexylcarbodiimide, 1,3-diisopropylcarbodlimide and 1-(3-dimethylaminopropyl)-3-ethylcarbodiimide; and (b) polycarbodiimide compounds such as poly(1,3,5-triisopropylphenylene-2,4-carbodiimide). Among these, N,N'-diphenylcarbodiimide and N,N'-diisopropylphenylcarbodiimide are preferred because of a possibility of further improvement of the hydrolysis resistance of the back face side base sheet 76. Moreover, the molecular weight of the carbodiimide compound preferably falls within a range of 200 to 1,000, particularly 200 to 600. When the molecular weight is greater than the above upper limit, dispersibility of the carbodiimide compound in the resin may be impaired, whereas when the molecular weight is less than the above lower limit, dustability of the carbodiimide compound may be increased.

In addition, the back face side base sheet 7 preferably contains, in addition to the carbodiimide compound, an antioxidant in polyethylene naphthalate which is the principal component. When both the carbodiimide compound and the antioxidant are thus contained In the polyethylene naphthalate, the aforementioned hydrolysis resistance may be significantly improved, and furthermore, degradation of the carbodiimide compound may be suppressed. The content of the antioxidant is preferably no less than 0.05 parts by mass and no greater than 1 part by mass, and particularly preferably no less than 0.1 parts by mass and no greater than 0.5 parts by mass. When the content of the antioxidant is less than the above lower limit, the function of suppressing the degradation of the carbodiimide and the effect of improving the hydrolysis resistance may be deteriorated, whereas when the content of the antioxidant is greater than the above upper limit, the color tone of the back face side base sheet 7 is likely to be impaired. Specifically, the antioxidant is a hindered phenol compound or a thio ether compound. In particular, the hindered phenol compound is preferred because of a possibility of an effective improvement of the hydrolysis resistance of the back face side base sheet 76. The mass ratio of the content of the antioxidant to the content of the carbodiimide compound is preferably no less than 0.1 and no greater than 1.0, and particularly preferably no less than 0.15 and no greater than 0.8. When the mass ratio is less than the above lower limit, the effect of suppressing the hydrolysis of the carbodiimide per se may be insufficient, and to the contrary, even when the mass ratio is greater than the above upper limit, the effect of suppressing the hydrolysis of the carbodiimide may no longer be enhanced- In addition, the method for addition of the carbodiimide compound and the antioxidant may be conducted through a procedure in which the carbodiimide compound and the antioxidant are kneaded into polyethylene naphthalate, or a procedure in which the carbodiimide compound and the antioxidant are added in the polycondensation reaction for synthesizing the polyethylene naphthalate.

The amount of the terminal carboxyl group in the polyethylene naphthalate is no less than 10 eq/T (equivalents/10⁶ g) and no greater than 40 eq/T, particularly no less than 10 eq/T and no greater than 30 eq/T, and further preferably no less than 10 eq/T and no greater than 25 eq/T. When the amount of the terminal carboxyl group is greater than the above upper limit, the effect of improving the hydrolysis resistance exerted by the carbodiimide compound may be deteriorated, whereas when the amount of the terminal carboxyl group is less than the above lower limit, the productivity may be deteriorated.

Moreover, the back face side base sheet 7 preferably contains, in addition to polyethylene naphthalate, an aromatic polyester. When the aromatic polyester is thus contained in the polyethylene naphthalate, the knot strength, delamination resistance, mechanical strength and the like of the back face side base sheet 76 may be improved while the hydrolysis resistance of the back face side base sheet 76 is maintained. The content of the aromatic polyester is preferably no less than 1 part by mass and no greater than 10 parts by mass. When the content of the aromatic polyester falls within the above range, the knot strength, delamination resistance, mechanical strength and the like may be effectively improved. Specifically, as the aromatic polyester, polyesters obtained by copolymerizing a terephthalic acid component and 4,4'-diphenyldicarboxylic acid as a principal dicarboxylic acid component with ethylene glycol as a principal glycol component are preferred .

It is to be noted that the method for producing polyethylene naphthalate is not particularly limited, and various well-known processes such as a transesterification process and a direct esterification process may be employed. Moreover, the method for molding the back face side base sheet 76 and additives in a material for forming the back face side base sheet 7 are similar to those for the base film 4 of the base sheet 3,

The lower limit of the thickness of the back face side base sheet 7 is preferably 12 µm, and particularly preferably 25 µm. On the other hand, the upper limit of the thickness of the back face side base sheet 7 is preferably 50 µm, and particularly preferably 40 µm. When the thickness of the back face side base sheet 7 is less than the above lower limit, the effect of improving the durability of the back face side base sheet 7, which is imparted by the hydrolysis resistance of polyethylene naphthalate, may not be sufficiently exhibited, and furthermore disadvantages that the back face side base sheet 7 is difficult to handle, etc. may be caused. To the contrary, when the thickness of the back face side base sheet 7 is greater than the above upper limit, demands for reduction in thickness and weight of the solar battery module may not be satisfied.

### Adhesion Layer

As mentioned above, an adhesive layer is laminated between two of the superposed base sheet 3, gas barrier layer 6 and back face side base sheet 7 (the adhesion layer is omitted in each figure). Each layer is adhered and secured by the adhesive layer, leading to enhancement of the strength, durability, fastness properties and the like of the back sheet 1, and further to exhibition of the functions to seal and protect defects of the inorganic oxide layer.

An adhesive for lamination or a melt-extrudable resin is used as the adhesive that constitutes the adhesive layer. Examples of the adhesive for lamination include adhesives for dry lamination, adhesives for wet lamination, adhesives for hot melt lamination, adhesives for nonsolvent lamination, and the like. Among these adhesives for lamination, an adhesive for dry lamination that is superior in adhesive strength, durability, weather resistance and the like, and exhibits the functions to seal and protect defects (for example, scratches, pinholes, recessed parts or the like) of the surface of the inorganic oxide layer are particularly preferred.

Examples of the adhesive for dry lamination include polyvinyl acetate-based adhesives; polyacrylic acid ester-based adhesives that contain a homopolymer of an ethyl, butyl or 2-ethylhexyl ester or the like of acrylic acid or a copolymer of the acrylic acid ester with methyl methacrylate, acrylonitrile, styrene or the like, etc.; cyanoacrylate-based adhesives; ethylene copolymer-based adhesives that contain a copolymer of ethylene with a monomer such as vinyl acetate, ethyl acrylate, acrylic acid and methacrylic acid; cellulose-based adhesives; polyester-based adhesive; polyamide-based adhesives; polyimide-based adhesives; amino resin -based adhesives that contain a urea resin, a melamine resin or the like; phenol resin-based adhesives; epoxy-based adhesives; polyurethane-based adhesives; reactive (meth)acrylic adhesives; rubber-based adhesives that contain chloroprene rubber, nitrile rubber, styrene-butadiene rubber or the like; silicone-based adhesive; inorganic-based adhesives that contain an alkali metal silicate, low melting point glass or the like; and the like. Among these adhesives for dry lamination, polyurethane-based adhesives and, in particular, polyester urethane-based adhesives are preferred since these adhesives inhibit deterioration of the adhesive strength and/or the delamination caused by an outdoor long-term use of the back sheet 1 for a solar battery module and additionally reduce the deterioration such as yellowing of the adhesive layer. In addition, aliphatic polyisocyanates are preferred as a curing agent since they yield less thermal yellowing.

As the melt-extrudable resin, One type, or two or more types of thermoplastic resins such as polyethylene resins, polypropylene resins, acid-modified polyethylene resins, acid-modified polypropylene resins, copolymers of ethylene with acrylic acid or methacrylic acid, Surlyn resins, ethylene-vinyl acetate copolymers, polyvinyl acetate resins, copolymers of ethylene with acrylic acid ester or methacrylic acid ester, polystyrene resins and polyvinyl chloride resins may be used. It is to be noted that if extrusion lamination using the melt-extrudable resin is employed, in each sheet, a front face that is to be opposed to other sheet when being laminated is preferably subjected to a front face treatment such as the abovementioned anchor coating treatment, in order to achieve more superior adhesive strength.

The lower limit of the amount (in terms of solid content equivalent) of the laminated adhesive layer is preferably 1 g/m², and particularly preferably 3 g/m². On the other hand, the upper limit of the amount of the laminated adhesive layer is preferably 10 g/m², and particularly preferably 7 g/m². When the amount of the laminated adhesive layer is less than the above lower limit, the adhesive strength or the function to seal defects of the inorganic oxide layer may not be exhibited. On the other hand, when the amount of the laminated adhesive layer is greater than the above upper limit, the strength and/or durability may be deteriorated.

In addition, various additives such as e.g., a solvent, a lubricant, a crosslinking agent, an antioxidant, an ultraviolet ray-absorbing agent, a light stabilizer, a filler, a reinforcing fibber, a reinforcing agent, an antistatic agent, a fire retardant, a flame-resistant agent, a foaming agent, a fungicide and a pigment may be blended arbitrarily in the adhesive for lamination or the melt-extrudable resin for forming the adhesive layer for the purpose of improving and/or modifying the handleability, the heat resistance, the weather resistance, the mechanical properties and the like.

### Method for Producing Back Sheet 1

Next, the method for producing the back sheet 1 will be explained.

The method for producing the back sheet 1 includes: providing a base sheet 3; laminating a gas barrier layer 6 on the back face side of the base sheet 3; laminating a back face side base sheet 7 on the back face side of the gas barrier layer 6; and providing a colored layer 2 on the front face side of the base sheet 3.

The step of laminating the gas barrier layer 6 may be implemented by laminating the base film 4 of the base sheet 3 and the gas barrier layer 6 through adhesion using an adhesive, and the step of laminating the back face side base sheet 7 is also implemented by laminating the gas barrier layer 6 and the back face side base sheet 7 through adhesion using an adhesive. In addition, the step of providing a base sheet 3 is implemented by providing a white layer 5 on the front face of the base film 4. The providing a white layer 5 may also be implemented by applying onto front face of the base sheet 3, a coating liquid containing a white pigment, and furthermore a method in which the base sheet 3 and the white layer 5 each separately prepared are laminated through adhesion using an adhesive may also be employed. Moreover, the step of providing the colored layer 2 on the front face of the base sheet 3 (white layer 5) may be implemented by applying to the front face of the base sheet 3, a coating liquid containing a pigment. It is to be noted that the order of each step as described above is not particularly limited, and for example, it is possible that the base film 4, the gas barrier layer 6 and the back face side base sheet 7 are integrally laminated, then the white layer 5 is provided on the front face of the base film 4, and thereafter the colored layer 2 Is provided on the front face of the white layer 5.

### Method for Producing Solar Battery Module

Next, a method for producing a solar battery module using the back sheet 1 according to the embodiment of the present invention will be explained.

The method of production includes: (1) a step of laminating a transparent substrate 12, a sheet 13 that constitutes a front face side filler layer, a plurality of solar battery cells 14, a sheet 15 that constitutes a back face side filler layer, and the back sheet 1 according to the embodiment of the present invention in this order; and (2) a heat lamination step of integral formation through a vacuum heat lamination procedure in which the laminate is Integrated by vacuum aspiration and thermocompressed for bonding the same, or the like. In the method for producing the solar battery module 11, each face that is to be opposed to each other when being laminated may be subjected to a corona discharge treatment, an ozone treatment, a low temperature plasma treatment, a glow discharge treatment, an oxidization treatment, a primer coating treatment, an undercoat treatment, an anchor coating treatment or the like, etc.

### Transparent Substrate 12

The transparent substrate 12 is overlaid on the outermost surface, and is required (a) to exhibit transmissibility for rays of the sun and electrically insulating properties, (b) to exhibit superior mechanical, chemical and physical strength, more specifically, superior weather resistance, heat resistance, durability, water resistance, gas barrier properties against water vapor and the like, wind pressure resistance, chemical resistance, and fastness properties, and (c) to exhibit superior surface hardness, and a superior antifouling property to inhibit accumulation of stains, dirt and the like on a surface.

A glassy material or a synthetic resin is used as a material for forming the transparent substrate 12. Examples of the synthetic resin used for the transparent substrate 12 include polyethylene resins, polypropylene resins, cyclic polyolefin resins, fluorine-containing resins, polystyrene resins, acrylanitrile-styrene copolymers (AS resins), acrylonitrile-butadiene-styrene copolymers (ABS resins), polyvinyl chloride resins, fluorine-containing resins, poly(meth)acrylic resins, polycarbonate resins, polyester resins such as polyethylene terephthalate and polyethylene naphthalate, polyamide resins such as various types of nylons, polyimide resins, polyamideimide resins, polyaryl phthalate resins, silicone resins, polyphenylene sulfide resins, polysulfone resins, acetal resins, polyethersulfone resins, polyurethane resins, cellulose resins, and the like, Among these resin, fluorine-containing resins, cyclic polyolefin resins, polycarbonate resins, poly(meth)acrylic resins and polyester resins are particularly referred

In addition, in the case of the transparent substrate 12 made from a synthetic resin, it may be possible (a) to provide a transparent vapor deposition film of an inorganic oxide such as silicon oxide or aluminum oxide on one face thereof by PVD or CVD as mentioned hereinabove for the purpose of improving gas barrier properties and the like, and (b) to incorporate thereinto various types of additives such as e.g., a lubricant, a crosslinking agent, an antioxidant, an ultraviolet ray-absorbing agent, an antistatic agent, a light stabilizer, a filler, a reinforcing fiber, a reinforcing agent, a fire retardant, a flame-resistant agent, a foaming agent, a fungicide and a pigment for the purpose of improving and/or modifying the processability, heat resistance, weather resistance, mechanical properties, dimension accuracy, etc. thereof.

The thickness (average thickness) of the transparent substrate 12 is not particularly limited, and may be appropriately selected in accordance with the material employed such that desired strength, gas barrier properties and the like can be attained. The thickness of the transparent substrate 12 made from a synthetic resin Is preferably no less than 6 µm and no greater than 300 µm, and particularly preferably no less than 9 µm and no greater than 150 µm. In addition, the thickness of the transparent substrate 12 made of glass is about 3 mm, in general.

### Filler Layer

Moreover, the sheet 13 that constitutes a front face side filler layer and the sheet 15 that constitutes a back face side filler layer are filled around the solar battery 14 between the transparent substrate 12 and the back sheet 1 by being melted in the heat laminating, and thereafter being cooled to harden. These filler layer 13 and filler layer 15 exhibit adhesiveness to the transparent substrate 12 and the back sheet 1, as well as scratch resistance, shock absorbability to protect the solar battery 14, and the like. Further, the filler layer 13 and the filler layer 15 exhibits, in addition to the aforementioned various functions, transparency sufficient to transmit rays of the sun.

Ethylene-vinyl acetate copolymers are suitably used as a material for forming of the filler layer 13 and the filler layer 15, and besides, examples thereof include fluorine-containing resins, ionomer resins, copolymers of ethylene with acrylic acid or methacrylic acid, polyethylene resins, polypropylene resins, acid-modified polyolefin resins obtained by modifying polyolefin resin such as polyethylene with an unsaturated carboxylic acid such as acrylic acid, polyvinyl butyral resins, silicone resins, epoxy resins, (meth)acrylic resins, and the like. Among these synthetic resins, ethylene-vinyl acetate resins, fluorine-containing resins or silicone resins are particularly preferred in light of superior weather resistance, heat resistance, gas barrier properties and the like thereof.

Moreover, as the material for forming the filler layer 13 and the filler layer 15, there can be used a thermoreveresibly crosslinkable olefin polymer composition disclosed in Japanese Unexamined Patent Application, Publication No. 2000-34376, more specifically a composition that contains: (a) a modified olefin polymer modified with an unsaturated carboxylic anhydride and an unsaturated carboxylic acid ester, the modified olefin polymer having an average number of bonded carboxylic anhydride groups of no less than 1 per molecule and a ratio of the number of carboxylic acid ester groups to the number of carboxylic anhydride groups in the modified olefin polymer of 0.5 to 20; and (b) a hydroxyl group-containing polymer having an average number of bonded hydroxyl groups of no less than 1 per molecule, wherein a ratio of the number of hydroxyl groups of the component (b) to the number of carboxylic anhydride groups of the component (a) Is 0.1 to 5, or the like.

In addition, the material for forming the filler layer 13 and the filler layer 15 may contain as needed various types of additives such as e.g. a crosslinking agent, a thermal antioxidant, a light stabilizer, an ultraviolet ray-absorbing agent and a photo-antioxidant for the purpose of improving weather resistance, heat resistance, gas barrier properties and the like. Moreover, although the thickness (average thickness) of the filler layer 13 and the filler layer 15 formed (i.e., melted by heating and thereafter hardened) is not particularly limited, the thickness (average thickness) of the filler layer 13 and the filler layer 15 is preferably no less than 200 µm and no greater than 1,000 µm, and particularly preferably no less than 350 µm and no greater than 600 µm.

### Solar Battery Cell 14

The solar battery cell 14 Is a photovoltaic device that converts light energies to electric energies, and is disposed between the filler layer 13 and the filler layer 15. A plurality of solar battery cells 14 are laid on a substantially identical plane and somewhat apart from one another, and wired in series or in parallel, although not shown in the figure. As the solar battery cell 14, the following may be used, for example: crystalline silicon solar battery elements such as single crystalline silicon solar battery elements and polycrystalline silicon solar battery elements; amorphous silicon solar battery elements having a single junction structure, a tandem structure or the like; group 3 to 5 compound semiconductor solar battery elements such as gallium-arsenide (GaAs) and indium-phosphide (InP); group 2 to 6 compound semiconductor solar battery elements such as cadmium-telluride (CdTe) and copper-indium-selenide (CuInSe₂); and the like. Hybrid elements of the foregoing may also be used. In addition, the filler layer 13 or the filler layer 15 will be compactly filled between the plurality of solar battery cells 14.

### Heat Lamination Step

In the heat lamination step of the method for production, the colored layer 2 of the front face of the back sheet 1 and the filler layers 13, 15 are melted, and these molten resins are integrally joined. Thereafter, the colored layer 2 and the filler layers 13, 15 are hardened by cooling, resulting in the production of the solar battery module 11.

### Solar battery Module 11

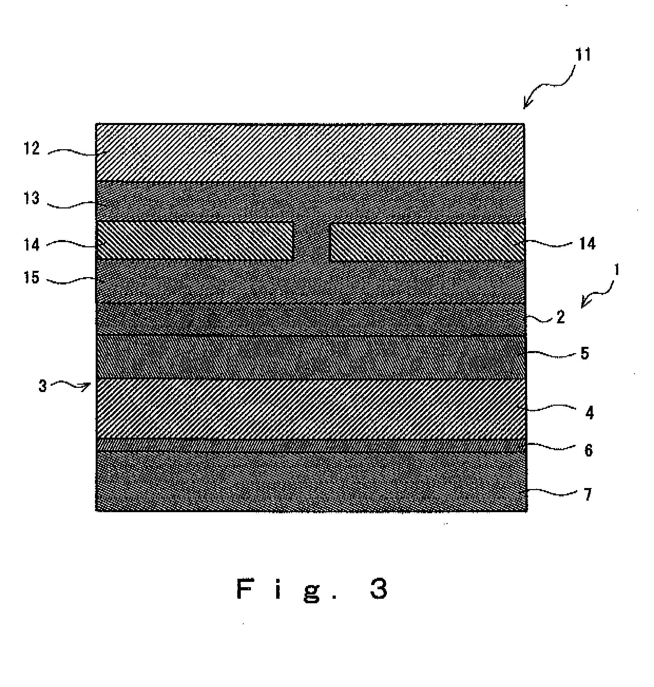

Fig. 3 illustrates a solar battery module 11 produced by the method for production, in which a transparent substrate 12, a filler layer 13, a plurality of solar battery cells 14, a filler layer 15, the back sheet 1 according to the embodiment of the present invention are laminated in this order from the front face side.

In the solar battery module 11 that has the aforementioned structure, three or more types of color materials contained in the colored layer 2 each have a different hue, and the colored layer 2 has a brightness L* of no greater than 40; therefore, the colored layer 2 displays a substantially black color, and a viewer hardly distinguishes the colored layer from solar battery cells. Thus, the solar battery module 11 is likely to be recognized as an integrated object, when viewed from the front face side.

Further, since the three or more types of pigments of the colored layer 2 each tend to absorb a visible light ray of a specific wavelength but is less likely to absorb an infrared light, a rise in temperature caused by the irradiation with rays of the sun can be suppressed even when the colored layer 2 displays a black color. Further, since each pigment of the colored layer 2 has a brightness L* of no less than 45, ordinary pigments may be used, and it is not necessary to use any special pigment, leading to suppression of an increase of costs. Moreover, even after a long-term use, discoloration is less likely to occur, as compared with conventional perylene-based black pigments. In particular, since a red color material, a blue color material and a yellow color material are used as the three or more types of pigments, the colored layer 2 can display a black color by merely using generally-used pigments. Further, since not a dye but a pigment is used as the color material, the colored layer 2 exhibiting superior durability can be obtained at a lower cost.

Moreover, since the colored layer 2 is laminated on the front face side of the base sheet 3 and thus supported by the base sheet 3, the colored layer 2 can be provided easily and stably. In addition, since the base sheet 3 displays a white color and the colored layer 2 is laminated on the front face side of the base sheet 3, rays of light (for example, an infrared light) that pass through the colored layer 2 among the rays of light that enter the colored layer 2 from the front face side of the colored layer 2 are reflected by the base sheet 3 that displays a white color, and a part of the reflected rays of light pass again through the colored layer 2 and exit from the front face side. Since a part of the rays of light reflected by the base sheet 3 and passed again through the colored layer 2 in this manner enter the solar battery cell, the efficiency of photoelectric conversion of the solar battery module can be increased, and consequently the efficiency of electric power generation can be increased.

Furthermore, since the base sheet 3 includes the base film 4, and the white layer 5 laminated on the front face side of the base film 4, a white-colored base sheet 3 can be easily and reliably provided. It is to be noted that the white layer 5 may be laminated on the back face side of the base film 4, and the base film 4 may be made from a transparent or translucent material. However, by providing the white layer 5 on the front face side of the base sheet 3 as in the aforementioned embodiment, it is not necessary to cause the retroreflected rays of light to pass again through the base film 4, and as a result, the efficiency of reflection of the rays of light by the base sheet 3 can be increased.

### Other Embodiments

It is to be noted that the present invention is not limited to the configurations described in the aforementioned embodiments. More specifically, although in the foregoing, the embodiment in which the colored layer 2 is provided on the outermost surface has been explained, the present invention is not limited thereto. For example, a transparent or translucent heat-welded layer may be provided on the front face of the colored layer 2 of the aforementioned embodiment.

Furthermore, although in the foregoing, the embodiment in which the base sheet 3 displays a white color has been explained, the present Invention is not limited thereto. For example, the base sheet 3 may be transparent or translucent. In addition, in this instance, the colored layer 2 may be laminated on the back face side of the base sheet 3.

Further, even if the base sheet 3 displays a white color, the present invention is not limited to the embodiment in which the white layer 5 is provided as in the aforementioned embodiment. The aforementioned embodiment may be appropriately modified such that a white synthetic resin sheet is employed as the base sheet 3.

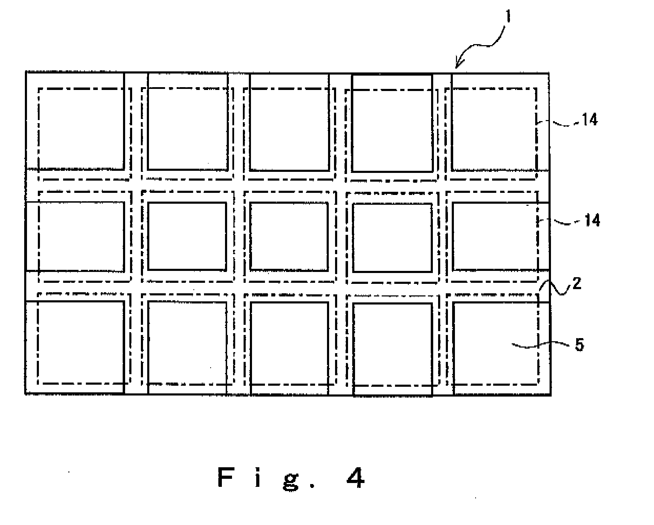

Furthermore, although in the foregoing, the embodiment in which the colored layer 2 is provided over the entire front face of the base sheet 3 has been explained, the present invention is not limited thereto. More specifically, it is contemplated within the scope of the present invention that, for example, the colored layer 2 is provided on only a part of the front face of the base sheet 3. In particular, the colored layer 2 of the back sheet 1 may be provided substantially in a grid pattern In a planar view, as shown in Fig. 4, and the solar battery cells 14 of the solar battery module may be provided such that the solar battery cells 14 cover a gap portion in a planar view (a portion that is partitioned by the grid and in which the white layer 5 is exposed) of the colored layer 2. Thus, the entire surface of the solar battery module displays a black color when viewed from the front face side, and in addition, the amount of the pigments (color materials) used can be reduced because of the limited area of the colored layer 2, leading to a further reduction of costs.

Further, although in the foregoing, the embodiment in which the colored layer 2 has a monolayer structure has been explained, the colored layer 2 may have a bilayer structure. Specifically, the colored layer 2 may be constituted with a plurality of layers that each differ in the color material contained therein. More specifically, for example, a first layer that contains a blue color pigment may be laminated on the front face of the base sheet 3, a second layer that contains a red color pigment and a yellow color pigment may be laminated on the front face of the first layer, and the colored layer 2 may be constituted with these first layer and second layer. Alternatively, a first layer that contains a blue color pigment may be laminated on the front face of the base sheet 3, a second layer that contains a red color pigment may be laminated on the front face of the first layer, and a third layer that contains a yellow color pigment may be laminated on the front face of the second layer, and the colored layer 2 may be constituted with these first layer, second layer and third layer.

Furthermore, it is contemplated within the scope of the present invention that the colored layer is provided on the front face of the base sheet in a dotted pattern. Specifically, the colored layer may be provided by making dot printing over the entire front face of the base sheet. In this instance, although all of a plurality of dots may contain a plurality of color materials such that all of the plurality of dots display a black color, the plurality of dots may be provided such that the plurality of dots each display a different color. More specifically, for example, a group of first dots that contain a red color pigment, a group of second dots that contain a blue color pigment, and a group of third dots that contain a yellow color pigment may be substantially evenly provided, and consequently the base sheet may display a black color when viewed from the front face side.

Furthermore, although in the foregoing, the embodiment in which the colored layer is provided by applying has been explained, the colored layer may be constituted with, for example, a colored film, and the back sheet may be obtained by sticking the colored film to the front face of the base sheet.

Further, the back sheet 1 may have a structure In which the gas barrier layer 6 and/or the back face side base sheet 7 is not involved, and the back sheet 1 may be modified such that other layer is provided.

### Example 1

Hereinafter, the experimental results of the invention are specifically explained by way of Example, but the invention is not limited to the following Example.

### Reflectance in Accordance with Difference of Amount of Coating

The colored layer 2 of the back sheet 1 was provided by applying a coating liquid on the front face of the base sheet 3 (white layer 5), and the reflectance thereof was measured.

A laminate obtained by laminating a polyethylene film having a thickness of 110 µm (W-PO (white), manufactured by Keiwa Inc.) as the white layer 5, and a polyester film having a thickness of 188 µm (S10 (transparent), manufactured by Toray Industries, Inc.) and a polytetrafluoroethylene film having a thickness of 25 µm (25PWA, manufactured by Asahi Glass Co., Ltd.) as a base film 4 was used as the base sheet 3.

In addition, a liquid obtained by blending a red color pigment having a concentration of 27% (LAMIC SR915Rrouge, manufactured by Dainichiseika Color & Chemicals Mfg. Co., Ltd.) In a blend ratio of 34.9%, a blue color pigment having a concentration of 27% (LAMIC SR739Rindigo blue, manufactured by Dainichiseika Color & Chemicals Mfg. Co., Ltd.) in a blend ratio of 39.8%, and a yellow color pigment having a concentration of 27% (LAMIC SR722R yellow, manufactured by Dainichiseika Color & Chemicals Mfg. Co., Ltd.) in a blend ratio of 25.3% was used as the coating liquid. The coating liquid was applied on the front face of the base sheet 3, with the amount of the coating liquid of 2.8 g/m², 3.5 g/m², 5.3 g/m² or 7.6 g/m²

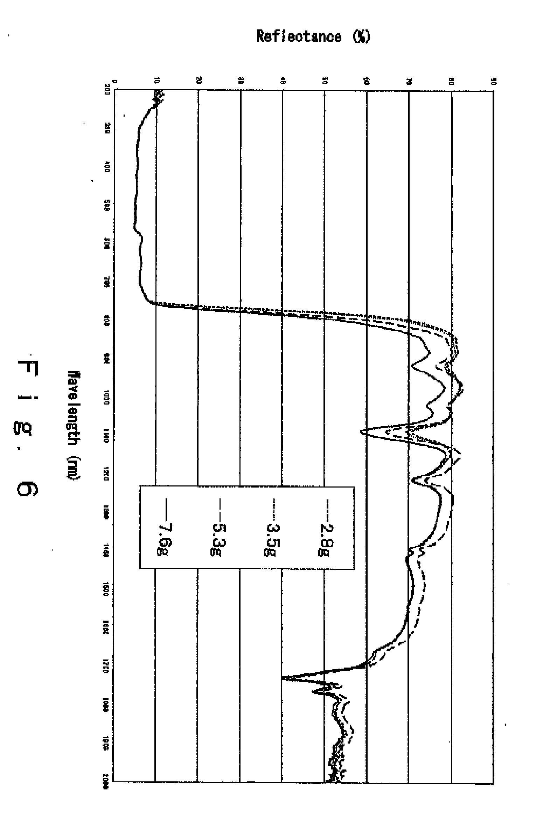

As is clear from a graph shown in Fig. 6, it was confirmed that the base sheet 3 having a less amount of coating exhibited a higher reflectance with respect of a wavelength range of 800 nm to 1,200 nm. Based on the trend found in the graph, it can be presumed that a further less amount of coating will result in a further increase of the reflectance with respect of the abovementioned wavelength range, leading to a reduction of costs.

### Reflectance in Accordance with Difference of Coating Method

Next, the colored layer 2 of the back sheet 1 was provided by applying a coating liquid on the front face of the base sheet 3 (white layer 5). The reflectance of the colored layer 2 was measured, and compared in regard to two types of coating method (coating method A and coating method B) as well as a case where a carbon black was applied on the front face of the back sheet (coating method C).

In all coating methods, the base sheet 3 used was a laminate obtained by laminating a polyethylene film having a thickness of 110 µm (W-PO (white), manufactured by Keiwa Inc.) as a white layer 5, and a polyester film having a thickness of 188 µm (S10 (transparent), manufactured by Toray Industries, Inc.) and a polytetrafluoroethylene film having a thickness of 25 µm (25PWA, manufactured by Asahi Glass Co., Ltd.) as a base film 4.

### Coating Method A

A liquid obtained by blending a red color pigment having a concentration of 27% (LAMIC SR915R rouge, manufactured by Dainichiseika Color & Chemicals Mfg. Co., Ltd.) in a blend ratio of 34.9%, a blue color pigment having a concentration of 27% (LAMIC SR739R indigo blue, manufactured by Dainichiseika Color & Chemicals Mfg. Co., Ltd.) in a blend ratio of 39,8%, and a yellow color pigment having a concentration of 27% (LAMIC SR722R yellow, manufactured by Dainichiseika Color & Chemicals Mfg. Co., Ltd.) in a blend ratio of 25.3% was used as the coating liquid. Then, the coating liquid was applied on the front face of the base sheet 3. It is to be noted that the amount of coating was 1.5 g/m². The brightness L* determined from the side where the colored layer 2 can be seen was 24.17.

### Coating Method B

Three types of coating liquids were each applied in a dotted pattern on the front face of the base sheet 3 in the following proportion:
(1) A red color pigment having a concentration of 27% (LAMIC SR915R rouge, manufactured by Dainichiseika Color & Chemicals Mfg. Co., Ltd.) was applied in a proportion of 80% with respect to the front face of the base sheet 3 (80% per unit area).
(2) A blue color pigment having a concentration of 27% (LAMIC SR739R indigo blue, manufactured by Dainichiseika Color & Chemicals Mfg. Co., Ltd.) was applied in a proportion of 80% with respect to the front face of the base sheet 3 (80% per unit area).
(3) A yellow color pigment having a concentration of 27% (LAMIC SR722R yellow, manufactured by Dainichiseika Color & Chemicals Mfg. Co., Ltd.) was applied in a proportion of 20% with respect to the front face of the base sheet 3 (20% per unit area).

In this method, the brightness L* determined from the side where the colored layer 2 can be seen was 39.76. In addition, the colored layer 2 displayed a substantially black color in appearance.

### Coating Method C

A coating liquid that contained a carbon black as a coloring pigment was applied on the front face of the base sheet 3. The brightness L* determined from the side where the colored layer 2 can be seen was substantially zero.

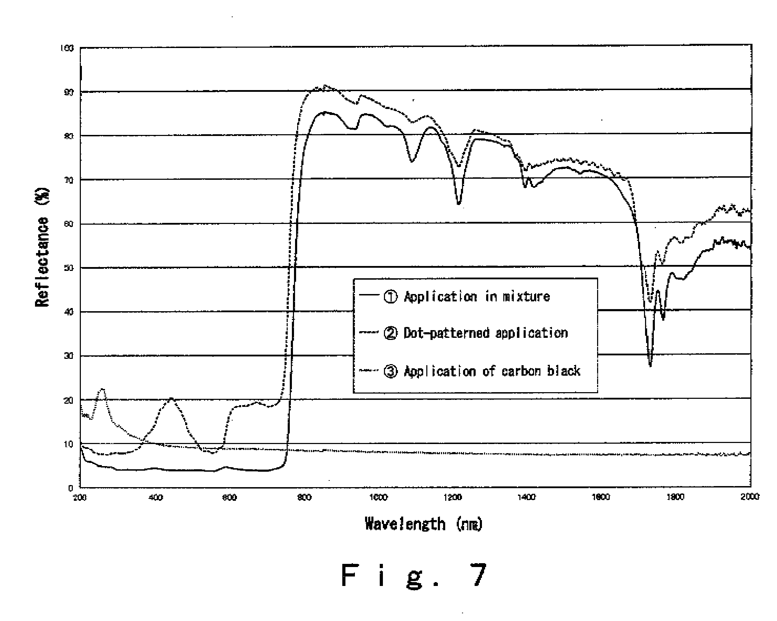

As is clear from a graph shown in Fig. 7, the coating method A and the coating method B resulted in a favorable reflectance with respect to a wavelength range of no less than 800 nm, as compared with the coating method C in which the carbon black were applied. Moreover, it was confirmed that the coating method B in which the coating was conducted in a dotted pattern yielded a higher reflectance with respect to a wavelength range of 200 nm to 800 nm, as compared with the coating method A in which the color materials were blended before the application. As is well known, most solar battery modules used in solar batteries can utilize also a wavelength range of no greater than 800 nm for the generation of electric power, and the reflection of rays of light having a wavelength of no greater than 800 nm is likely to lead to an increase of the efficiency of the solar batteries. Thus, it was revealed that the coating in a dotted pattern had a more significant influence on the increase of the efficiency of the solar batteries, and led to a reduction of costs because of the necessity of a less amount of color materials, as compared with the coating after blending.

### [INDUSTRIAL APPLICABILITY]

As described in the foregoing, the present invention is useful as a constitutive element of solar batteries, and in particular, can be suitably used in fixed roof stationary solar batteries which have been increasingly becoming popular, as well as in solar batteries for small-sized electric equipment such as electric calculators, and the like.

### [Explanation of the Reference Symbols]

- 1: back sheet
- 2: colored layer
- 3: base sheet
- 4: base film
- 5: white layer
- 6: gas barrier layer
- 7: back face side base sheet
- 11: solar battery module
- 12: transparent substrate
- 13: filler layer
- 14: solar battery cell
- 15: filler layer

## Claims

1. A back sheet for a solar battery module, comprising:
a colored layer that comprises three or more types of color materials each having a different hue and a brightness L* of no less than 45,
the colored layer having a brightness L* of no greater than 40.

2. The back sheet for a solar battery module according to clam 1. further comprising a base sheet on which the colored layer Is laminated.

3. The back sheet for a solar battery module according to claim 2, wherein:
the base sheet displays a white color, and
the colored layer is laminated on a front face side of the base sheet.

4. The back sheet for a solar battery module according to claim 3, wherein the base sheet comprises a base film, and a white layer laminated on a front face side of the base film.

5. The back sheet for a solar battery module according to claim 2, wherein the colored layer is provided substantially in a grid pattern in a planar view.

6. The back sheet for a solar battery module according to claim 1, wherein the three or more types of color materials are constituted with at least a red color material, a blue color material and a yellow color material.

7. The back sheet for a solar battery module according to claim 1, wherein the color material is a pigment.

8. A method for producing a back sheet for a solar battery module, comprising providing a colored layer on one face side of a base sheet by applying a material for forming a colored layer that comprises three or more types of color materials each having a different hue and a brightness L* of no less than 45.

9. A solar battery module comprising a transparent substrate, a filler layer, a solar battery cell as a photovoltaic device, a filler layer, the back sheet for a solar battery module according to any one of claims 1 to 7, overlaid in this order from a front face side.
